# EUROPEAN PATENT SPECIFICATION

(11) **EP 0 424 866 B1**
(45) Date of publication and mention of the grant of the patent: **02.04.1997**
(21) Application number: 90120278.8
(22) Date of filing: 23.10.1990
(51) Int. Cl.: G03F 7/027, G03F 7/033

(54) **Liquid solder mask composition**
Flüssige Lötstoppmasken-Zusammensetzung
Composition liquide pour masque de soudure

(30) Priority: 25.10.1989 US 426255
(43) Date of publication of application: 02.05.1991
(73) Proprietor: MacDermid Imaging Technology Inc., Waterbury, CT 06702 (US)
(72) Inventor: Varnell, Daniel Felix, Wilmington, Delaware 19808 (US)
(74) Representative: von Kreisler, Alek, Dipl.-Chem.

(56) References cited:
- EP-A- 0 128 014
- EP-A- 0 173 057
- EP-A- 0 233 623
- EP-A- 0 259 812
- EP-A- 0 283 990

## Description

This invention relates to solder masks used in the manufacture of printed circuit boards.

Solder masks provide protection to the circuitry on printed circuit boards during processing, as well as providing continued protection throughout the life of the circuit board. These masks must be resistant to solder compositions as well as etching fluids such as methylene chloride, and also withstand environmental stresses such as changes in temperature and humidity. At the same time they must remain flexible enough to withstand mechanical stresses without cracking or peeling. The Institute of Interconnecting and Packaging Electronic Circuitry (IPC) describes requirements for solder mask coatings in their SM840-B specifications. The specifications include, among other things, hydrolytic stability, electrical resistivity, thermal stability, abrasion resistance, solvent resistance, and limited flammability. The requirements for a Class III material are the most severe, since these materials are used for life support systems and military equipment.

The solder mask composition is applied to a circuit board and partially cured in the desired areas by exposure to ultraviolet radiation through a phototool or negative. After the unexposed composition is removed from the board by washing with an aqueous solution or an organic solvent, the partially cured mask is fully cured by further exposure to ultraviolet radiation or a combination of irradiation and thermal curing.

EP-0 233 623 A3 discloses an aqueous developable photopolymerizable composition having increased flexibility and reduced cold flow comprising an unique mixture of a siliceous material and a plasticizer in combination with known photopolymerizable monomers, polymeric binders, thermal polymerization inhibitors and photoinitiators.

EP-0 259 812 A2 discloses photopolymerizable compositions containing inorganic fillers. Improved performance in photopolymerizable compositions has been obtained by mixing inorganic filler with polymeric binder prior to incorporation of monomer.

Although photopolymerizable compositions containing an acrylic binder, a multifunctional (meth)acrylate monomer, a solvent and a photoinitiator have been described, for example, in U.S. patents 4,629,680; 4,845,011 and 4,504,573, these compositions do not possess the unique properties required for use as a solder mask, i.e., resistance to immersion in molten solder and formation of a permanent protective coating on a printed circuit board.

There is a need for a solder mask composition that can be applied as a liquid and subsequently dried to provide the advantages of easy handling of the coated circuit board, control of film thickness and elimination of the need for vacuum lamination, which is required when using dry film solder masks.

The liquid, aqueous-developable, UV-curable solder mask composition of this invention free of plasticizer and thermal polymerization inhibitor, containing an acrylic binder, a photoinitiator, a multifunctional meth(acrylate) monomer, and a solvent, is characterized in that it consists essentially of (1) 40% to 70% of a nonreactive binder that is a film-forming random copolymer prepared from (a) one or more acrylic or methacrylic alkyl ester monomers, at least one of which is an ester of a 4-12 carbon alkanol, (b) methacrylic or acrylic acid, and optionally (c) styrene or α-methylstyrene, (2) 20% to 40% of one or more acrylic or methacrylic ester monomers containing two or more ethylenic double bonds, wherein at least one of the monomers has at least four ethylenic double bonds, (3) 1% to 5% of the photoinitiator, (4) 5% to 15% of a filler, all percentages being by weight based on the non-solvent components of the composition, and (5) 35% to 70% of an organic solvent or mixture of organic solvents, based on the total weight of the composition.

The filler added to the (meth)acrylate binder and meth(acrylate) monomers specified in the solder mask composition of this invention improves adhesion, serves as a rheology modifier, reduces tackiness and improves solvent resistance.

The nonreactive film-forming polymer binder of the present invention preferably has a weight average molecular weight (M_{w}) between 50,000 and 200,000 g/mole, preferably 75,000 to 150,000, and a polydispersity (number average molecular weight/M_{w}) less than 5, preferably less than 3. In any of these binders there is preferably a minimum of variation in composition from one polymer chain to the next. The binder is a random copolymer of (a) one or more acrylic or methacrylic alkyl ester monomers, at least one of which is an ester of a 4-12 carbon alkanol, (b) methacrylic acid or acrylic acid, and optionally (c) styrene or α-methylstyrene. The weight % of methacrylic or acrylic acid is typically between 15% and 25%. By "nonreactive" binder is meant one that does not take part in a cross-linking reaction and does not react with the multifunctional monomers. The binder and monomers are believed to form a "semi-interpenetrating network" where the two components are not chemically bound to each other and where the binder does not cross-link, but the multifunctional monomer does. Typical acrylic and methacrylic ester monomers that are suitable for use in the preparation of the binder include, for example, butyl (meth)acrylate, methyl (meth)acrylate, lauryl (meth)acrylate, pentyl (meth)acrylate, and ethyl (meth)acrylate. The binder is present in the composition in an amount of 40 to 70 weight % of the nonsolvent components.

Multifunctional acrylic or methacrylic ester monomers having two or more ethylenic double bonds that are suitable for use as component (2) of the composition of this invention include, for example, trimethylolpropane triacrylate, pentaerythritol triacrylate, pentaerythritol tetraacrylate, dipentaerythritol pentaacrylate, tripropylene glycol di-acrylate, di-trimethylolpropane tetraacrylate, bis-phenol A diacrylate, bis-phenol A dimethacrylate, and the diacrylate or dimethacrylate of a polyethylene glycol adduct of bis-phenol A with 2 to 20 ethylene oxide units. The preferred monomers having at least four ethylenic double bonds are pentaerythritol tetraacrylate and dipentaerythritol pentaacrylate. These monomers preferably nave a weight average molecular weight of less than 1100 g/mole. The monomers are present in an amount of 20 to 40 wt. % of the nonsolvent components, preferably between 25% and 35%.

Any conventional photoinitiator that is activatable by actinic radiation but that is thermally inactive at temperatures below 160°C can be used as component (3) of the composition of this invention. Examples of useful photoinitiators are found in U.S. Patent 4,268,610. Preferred photoinitiators include α,α-dimethoxyphenylacetophenone, benzophenone, 2-methyl-1-[4-(methylthio)phenol]-2-morpholinopropanone-1 and ethyl 4-(dimethylamino)-benzoate. In addition, photosensitizers such as Michlers' ketone and isopropylthioxanthone can be added. The photoinitiator is present in an amount of 1 to 5 weight % of the nonsolvent components.

The composition of this invention also includes one or more organic solvents. The evaporation rate of the solvent, or mixture of solvents, should be fast enough so as not to be a hindrance to commercial use and in general falls between 1 and .01, where the rate of evaporation of butyl acetate is taken as equal to 1. For screen printing, the preferred range is from .1 to .01. Those skilled in the art can combine solvents to produce a film with good leveling properties, suitable "out-time" (time that it can remain on the screen before it becomes too thick to use), and a drying rate fast enough so that it is not a hindrance to commercial use. Typical compositions contain 35% to 70% solvent, based on the total weight of the composition. Suitable solvents include, for example, butyl acetate, isobutyl acetate, propylene glycol monomethyl ether, ethylene glycol monobutyl ether, dimethylformamide and dipropylene glycol monomethyl ether.

A finely divided filler such as, for example, aluminum oxide, silicon dioxide, talcum, mica, or kaolin, is added to the composition in an amount of 5% to 15% by weight, based on the nonsolvent components of the composition. The average particle size of the filler is generally less than 0.3 micron.

The composition can optionally include an adhesion promoter such as the 4-methyl and 5-methyl isomers of tolutriazole-formaldehyde-diethanolamine. If an adhesion promoter is used, it is present in an amount of 0.05 to 0.30%, based on the weight of the nonsolvent components. Other additives well known in the art such as antioxidants and pigments can also be present.

The solder mask compositions of this invention are coated from solution onto a clean printed wiring board on which circuit patterns have been formed. The coating is typically applied by screen coating, but roll coating, dip coating and curtain coating can also be used. The board does not have to be held in a horizontal position during coating and coatings can be applied to one or both sides. The coating is then dried to remove the solvent at temperatures from ambient to about 150°C, typically at about 75° to 100°C. Unlike some prior art compositions, the compositions of this invention can be completely cured without the addition of a thermally activated cross-linking agent and drying time is not critical. The compositions of this invention are thermally stable and the desired properties do not deteriorate even when the drying is continued 10 to 20 times longer than customary. Following drying, the masks are photoimaged by ultraviolet actinic radiation to produce a pattern of cured and uncured areas. The uncured material is washed away (the developing step) by an aqueous alkaline solution, typically .75% to 1.5% Na₂CO₃ at 29° to 46°C. The solder mask is post-cured with ultraviolet light (typically 3 to 5 J/cm²) and heated, typically for 1 to 1.5 hours at 150° to 170°C. The circuit board is then ready for the application of solder and circuitry by methods well known to those skilled in the art.

The cured solder mask compositions of this invention pass Class I, Class II and Class III requirements as described by the Institute of Interconnecting and Packaging Electronic Circuitry (IPC) in their SM840-B specification.

### Example 1

A solution of the ingredients listed in Table 1 is prepared by dispersing the silicon dioxide and phthalocyanine green pigment in a 50% solution of polymeric binder and ethylene glycol monomethyl ether using a high shear mixer. The remaining ingredients are added and the mixture is stirred for 1.5 hours to obtain a uniform solution. Films are formed on a copper clad epoxy-fiberglass laminate by screen coating with a 0,4 mm (40 mesh) screen. Films are also formed on copper and tin/lead wiring boards with an IPC B25 test pattern.

The coatings are dried by baking in a vented oven at 100°C for 20 minutes. Testing for residual solvents showed less than .01% ethylene glycol monomethyl ether remaining in the films. The residual solvent tests are run on a gel permeation chromatograph. The coatings are then imaged through diazo film with ultraviolet light from a medium pressure mercury vapor arc lamp. The unexposed and thus uncured portions are developed away in a dilute alkaline solution (.75% NaCO₃) at 29°C with 20 psi (1.4/kg/cm²) spray pressure, rinsed with water and dried. The samples are then blanket exposed with 6 J/cm² of UV light and heated for one hour at 150°C.

The samples are subjected to IPC tests for solder mask materials and are found to meet IPC Class III requirements. The samples are stable during immersion for 10 seconds in molten solder at 260°C.

**TABLE 1**

| Component | Parts |
|---|---|
| 1. 50% solution of acrylic polymer* in ethylene glycol monomethyl ether | 120.0 |
| 2. Precipitated silica | 10.0 |
| 3. Ethylene glycol monomethyl ether | 20.0 |
| 4. Ethylene glycol monobutyl ether | 20.0 |
| 5. Trimethylolpropane triacrylate | 1.60 |
| 6. Pentaerythritol tetraacrylate | 15.0 |
| 7. Dipentaerythritol pentaacrylate | 4.0 |
| 8. Dimethylacrylate adduct of an ethoxylated bisphenol A (Mw = approximately 800) | 4.0 |
| 9. α,α-Dimethoxyphenylacetophenone | 5.0 |
| 10. Phthalocyanine green pigment | 0.40 |

| | |
|---|---|
| *A random copolymer of methacrylic acid (22%), methyl methacrylate (20%), lauryl methacrylate (25%) and ethyl acrylate (33%). | |

### Example 2

Samples A, B, C and D are prepared as described in Example 1, using the components listed in Table 2, with the exception that various drying times and temperatures are used for the final heat treatment. These temperatures and times are listed in Table 3.

**TABLE 2**

| Component | Parts |
|---|---|
| 1. 50% solution of acrylic polymer* in ethylene glycol monobutyl ether | 125.0 |
| 2. Aluminum oxide | 4.0 |
| 3. Fumed silica | 4.0 |
| 4. Ethylene glycol monobutyl ether | 27.5 |
| 5. Dipropylene glycol monomethyl ether | 10.0 |
| 6. Dipentaerythritol pentaacrylate | 25.0 |
| 7. Propoxyglycerol triacrylate | 8.0 |
| 8. α,α-Dimethoxyphenylacetophenone | 5.0 |
| 9. Phthalocyanine green pigment | 0.40 |
| 10. Tolutriazole-formaldehyde-diethanol amine (4-methyl and 5-methyl isomers) | 0.20 |
| 11. Trimethylolpropane triacrylate | 1.60 |

| | |
|---|---|
| *Random copolymer of 60% butyl acrylate, 20% methyl methacrylate, 20% methacrylic acid. | |

**TABLE 3**

| Sample | Drying Temperature | Drying Time |
|---|---|---|
| A | 100°C. | 15 min. |
| B | 70°C. | 20 min. |
| C | 100°C. | 60 min. |
| D | 150°C. | 30 min. |

## Claims

1. A liquid, aqueous-developable, UV-curable solder mask composition free of plasticizer and thermal polymerization inhibitor and consisting essentially of (1) 40 % to 70 % of a non-reactive acrylic binder of a film-forming random copolymer prepared from (a) one or more acrylic or methacrylic alkyl ester monomers, at least one of which is an ester of a 4-12 carbon alkanol, (b) methacrylic or acrylic acid, and optionally (c) styrene or α-methylstyrene, (2) 20 % to 40 % of a multifunctional meth(acrylate)monomer of one or more acrylic or methacrylic ester monomers containing two or more ethylenic double bonds, wherein at least one of the monomers has at least four ethylenic double bonds, (3) 1 % to 5 % of a photoinitiator, (4) 5 % to 15 % of a filler, all percentages being by weight based on the non-solvent components of the composition, and (5) 35 % to 70 % of an organic solvent or mixture of organic solvents, based on the total weight of the composition.

2. The composition as claimed in claim 1, further characterized in that component (1) is a random copolymer of butyl acrylate, methyl methacrylate and methacrylic acid.

3. The composition as claimed in claims 1 or 2, further characterized in that the nonreactive binder has a weight average molecular weight of 50,000 to 200,000 g/mole.

4. The composition as claimed in claim 3, further characterized in that the weight average molecular weight is 75,000 to 150,000 g/mole.

5. The composition as claimed in any of the preceding claims, further characterized in that the polydispersity of the nonreactive binder is less than 5.

6. The composition as claimed in claim 5, further characterized in that the polydispersity is less than 3.

7. The composition as claimed in any of the preceding claims, further characterized in that the content of acrylic or methacrylic acid in the nonreactive binder is 15% to 25% by weight.

8. The composition as claimed in any of the preceding claims, further characterized in that the weight average molecular weight of the (meth)acrylic ester monomer is less than 1100 g/mole.

9. The composition as claimed in any of the preceding claims, further characterized in that the filler is silica.

10. The composition as claimed in any of the preceding claims, further characterized in that the monomer having at least four ethylenic double bonds is pentaerythritol tetraacrylate or dipentaerythritol pentaacrylate.

11. The composition as claimed in any of the preceding claims, further characterized in that it comprises an adhesion promoter.

12. The solder mask composition as claimed in any of the preceding claims, characterized in that it meets Class III (IPC) requirements after curing.

13. Use of the solder mask composition as claimed in any of the preceding claims to coat a circuit board.

## Patentansprüche

1. Flüssige, wässrig entwickelbare, UV-härtbare, von Weichmacher und thermischem Polymerisations-Inhibitor freie Lötmasken-Zusammensetzung, im wesentlichen bestehend aus (1) 40 % bis 70 % eines nichtreaktionsfähigen Acryl-Bindemittels aus einem filmbildenden, statistischen Copolymer, hergestellt aus (a) einem oder mehreren Acryloder Methacrylalkylestermonomeren, wobei wenigstens eines davon ein Ester eines 4-12-Kohlenstoff-Alkanols ist, (b) Methacryl- oder Acrylsäure und gegebenenfalls (c) Styrol oder α-Methylstyrol, (2) 20 % bis 40 % eines polyfunktionellen Meth(acrylat)monomers von einem oder mehreren Acryl- oder Methacrylestermonomeren, das zwei oder mehr ethylenische Doppelbindungen enthält, wobei wenigstens eines der Monomere wenigstens vier ethylenische Doppelbindungen aufweist, (3) 1 % bis 5 % eines Photoinitiators, (4) 5 % bis 15 % eines Füllstoffs, wobei alle Prozentwerte auf das Gewicht bezogen sind, bezogen auf die Nicht-Lösungsmittel-Komponenten der Zusammensetzung, und (5) 35 % bis 70 % eines organischen Lösungsmittels oder einer Mischung aus organischen Lösungsmitteln, bezogen auf das Gesamtgewicht der Zusammensetzung.

2. Zusammensetzung nach Anspruch 1, weiterhin dadurch gekennzeichnet, daß Komponente (1) ein statistisches Copolymer aus Butylacrylat, Methylmethacrylat und Methacrylsäure ist.

3. Zusammensetzung nach Anspruch 1 oder 2, weiterhin dadurch gekennzeichnet, daß das nichtreaktionsfähige Bindemittel ein Gewichtsmittel der Molmasse von 50 000 bis 200 000 g/mol aufweist.

4. Zusammensetzung nach Anspruch 3, weiterhin dadurch gekennzeichnet, daß das Gewichtsmittel der Molmasse 75 000 bis 150 000 g/mol beträgt.

5. Zusammensetzung nach einem beliebigen der vorhergehenden Ansprüche, weiterhin dadurch gekennzeichnet, daß die Polydispersität des nichtreaktionsfähigen Bindemittels niedriger als 5 ist.

6. Zusammensetzung nach Anspruch 5, weiterhin dadurch gekennzeichnet, daß die Polydispersität niedriger als 3 ist.

7. Zusammensetzung nach einem beliebigen der vorhergehenden Ansprüche, weiterhin dadurch gekennzeichnet, daß der Acrylsäure- oder Methacrylsäure-Gehalt im nichtreaktionsfähigen Bindemittel 15 Gew.-% bis 25 Gew.-% beträgt.

8. Zusammensetzung nach einem beliebigen der vorhergehenden Ansprüche, weiterhin dadurch gekennzeichnet, daß das Gewichtsmittel der Molmasse des (Meth)acrylsäureestermonomers niedriger als 1100 g/mol ist.

9. Zusammensetzung nach einem beliebigen der vorhergehenden Ansprüche, weiterhin dadurch gekennzeichnet, daß der Füllstoff Siliciumdioxid ist.

10. Zusammensetzung nach einem beliebigen der vorhergehenden Ansprüche, weiterhin dadurch gekennzeichnet, daß das wenigstens vier ethylenische Doppelbindungen aufweisende Monomer Pentaerythrittetraacrylat oder Dipentaerythritpentaacrylat ist.

11. Zusammensetzung nach einem beliebigen der vorhergehenden Ansprüche, weiterhin dadurch gekennzeichnet, daß sie ein Haftmittel umfaßt.

12. Lötmasken-Zusammensetzung nach einem beliebigen der vorhergehenden Ansprüche, dadurch gekennzeichnet, daß sie nach dem Härten die Anforderungen der Klasse III (IPC) erfüllt.

13. Verwendung der Lötmasken-Zusammensetzung nach einem beliebigen der vorhergehenden Ansprüche zum Beschichten einer Leiterplatte.

## Revendications

1. Composition liquide de masque de soudure, développable à l'eau, durcissable sous l'action d'UV, dépourvue de plastifiant et d'inhibiteur de polymérisation thermique, et essentiellement constituée de (1) 40% à 70% d'un liant acrylique non réactif d'un copolymère statistique filmogène préparé à partir (a) d'un ou de plusieurs monomères ester alkylique acrylique ou méthacrylique, dont l'un au moins est un ester d'un alcanol de 4-12 atomes de carbone, (b) d'acide méthacrylique ou acrylique et, éventuellement, (c) de styrène ou d'a-méthylstyrène, (2) 20% à 40% d'un monomère méth(acrylate) multifonctionnel d'un ou de plusieurs monomères ester acrylique ou méthacrylique contenant deux doubles liaisons éthyléniques ou plus, où l'un au moins des monomères contient au moins quatre doubles liaisons éthyléniques, (3) 1% à 5% d'un photo-amorceur, (4) 5% à 15% d'une charge, tous les pourcentages étant en poids par rapport aux constituants non solvants de la composition et (5) 35% à 70% d'un solvant organique ou d'un mélange de solvants organiques, par rapport au poids total de la composition.

2. Composition selon la revendication 1, caractérisée en outre en ce que le constituant (1) est un copolymère statistique d'acrylate de butyle, de méthacrylate de méthyle et d'acide méthacrylique.

3. Composition selon la revendication 1 ou 2, caractérisée en outre en ce que le liant non réactif possède une masse moléculaire moyenne en poids de 50 000 à 200 000 g/mol.

4. Composition selon la revendication 3, caractérisée en outre en ce que la masse moléculaire moyenne en poids est de 75 000 à 150 000 g/mol.

5. Composition selon l'une quelconque des revendications précédentes, caractérisée en outre en ce que la polydispersité du liant non réactif est inférieure à 5.

6. Composition selon la revendication 5, caractérisée en outre en ce que la polydispersité est inférieure à 3.

7. Composition selon l'une quelconque des revendications précédentes, caractérisée en outre en ce que la teneur en acide acrylique ou méthacrylique dans le liant non réactif est de 15% à 25% en poids.

8. Composition selon l'une quelconque des revendications précédentes, caractérisée en outre en ce que la masse moléculaire moyenne en poids du monomère ester (méth)acrylique est inférieure à 1 100 g/mol.

9. Composition selon l'une quelconque des revendications précédentes, caractérisée en outre en ce que la charge est la silice.

10. Composition selon l'une quelconque des revendications précédentes, caractérisée en outre en ce que le monomère contenant au moins quatre doubles liaisons éthyléniques est le tétraacrylate de pentaérythritol ou le pentaacrylate de dipentaérythritol.

11. Composition selon l'une quelconque des revendications précédentes, caractérisée en outre en ce qu'elle comprend un promoteur d'adhérence.

12. Composition de masque de soudure selon l'une quelconque des revendications précédentes, caractérisée en ce qu'elle satisfait aux exigences de la classe III (IPC) après durcissement.

13. Utilisation de la composition de masque de soudure selon l'une quelconque des revendications précédentes pour revêtir une plaquette de circuits imprimés.
